# EUROPEAN PATENT APPLICATION

(11) **EP 0 700 947 A2**
(43) Date of publication of application: **13.03.1996**
(21) Application number: 95113576.3
(22) Date of filing: 29.08.1995
(51) Int. Cl.: C08G 59/24, C08G 59/62, H01L 23/29

(54) **Epoxy resin composition and resin-encapsulated semiconductor device**

(30) Priority: 08.09.1994 JP 214820/94
(71) Applicant: SUMITOMO CHEMICAL COMPANY, LIMITED, Osaka (JP)
(72) Inventor: Akiba, Masatsugu, Tsukuba-shi, Ibaraki-ken (JP); Shiomi, Yutaka, Toyonaka-shi, Osaka-fu (JP); Takebe, Kazuo, Ibaraki-shi, Osaka-fu (JP); Saito, Noriaki, Toyanaka-shi, Osaka-fu (JP); Morimoto, Takashi, Niihama-shi, Ehime-ken (JP)
(74) Representative: Henkel, Feiler, Hänzel & Partner

(57) **Abstract**

An epoxy resin composition comprising
(A) an epoxy resin represented by the general formula (1) 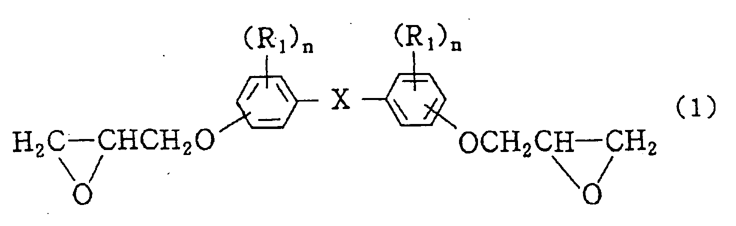 wherein R₁ represents hydrogen, an alkyl group having 1 to 6 carbon atoms, substituted- or nonsubstituted-phenyl groups or halogen, and X represents 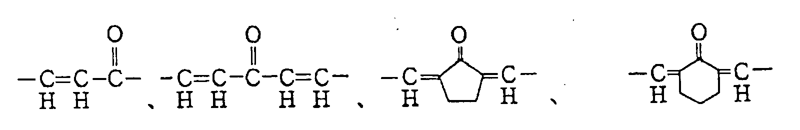 and n represents an integer of 0 to 4, and
(B) a curing agent, which composition provides a cured product having low hygroscopic property and high adhesiveness.

## Description

### BACKGROUND OF THE INVENTION

### Field of the Invention

The present invention relates to an epoxy resin composition useful for encapsulating electronic parts, and to a resin-encapsulated semiconductor device.

### Description of the Related Art

Recently, transfer molding has been conducted using an economically advantageous epoxy resin for encapsulating a semiconductor such as LSI, IC, transistor and the like.

Particularly, surface mounting of LSI has been conducted and a process of direct immersion in a solder bath has been increasingly employed. During the immersion, the encapsulating material is exposed to a high temperature not lower than 200 °C , and hence, such a problem occurs that the moisture contained in the encapsulating material is vaporized and expanded to cause cracks or cause peeling at the interface with a die pad.

For this reason, encapsulating resin materials are required to have less hygroscopicity, improved resistances to cracking and higher adhesiveness. Currently the most popular encapsulating materials are those using a glycidyl ether of o-cresol novolak as epoxy resin and a phenol novolak as curing agent.

The encapsulating materials comprising mainly glycidyl ethers of o-cresol novolak and phenol novolaks have a sort of balance between heat resistance and moldability, but are not sufficient for use in such applications as requiring a high level of non-hygroscopicity as described above, causing problems of solder cracking. They are marketed practically in the wrapped form with moisture-proof wraps to avoid the above problems.

### SUMMARY OF THE INVENTION

The objects of the invention are to provide an epoxy resin composition of low viscosity, which can give a cured product having low hygroscopicity and high adhesiveness, and to provide a semiconductor device encapsulated with the above epoxy resin composition.

In view of the aforementioned circumstances, the present inventors have made an intensive research on an epoxy resin composition, and as a result, found a composition with a specific epoxy resin which meets the objects and completed the invention.

The present invention provides an epoxy resin composition and a resin-encapsulated semiconductor device produced by encapsulating semiconductor devices with the same epoxy resin composition, characterized in that said epoxy resin composition comprises (A) an epoxy resin represented by the general formula (1) and (B) a curing agent, 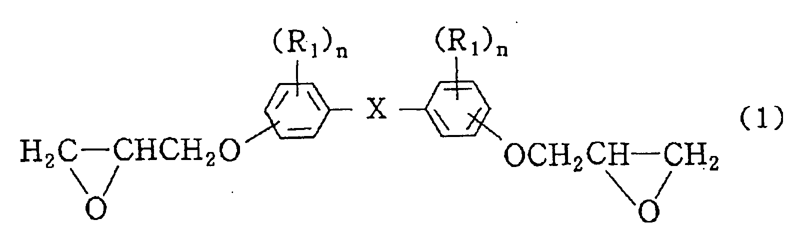
wherein in the above formula, R₁ represents hydrogen, an alkyl group having 1 to 6 carbon atoms, substituted- or nonsubstituted-phenyl groups or halogen, and X represents 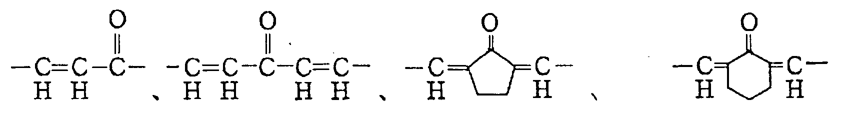
and n represents an integer of 0 to 4.

The substituent R₁ in the epoxy resin represented by the general formula (1) to be used as the component (A) in the present invention includes methyl, ethyl, propyl, butyl, amyl, hexyl, cyclohexyl, toryl and xylyl groups, chlorine and bromine atoms, including various isomers thereof.

### BRIEF DESCRIPTION OF THE DRAWING

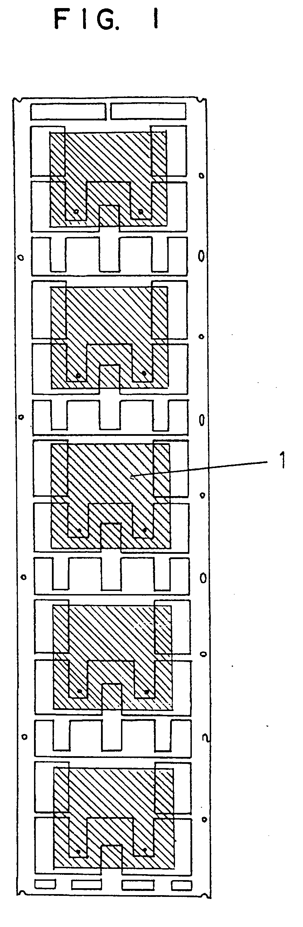

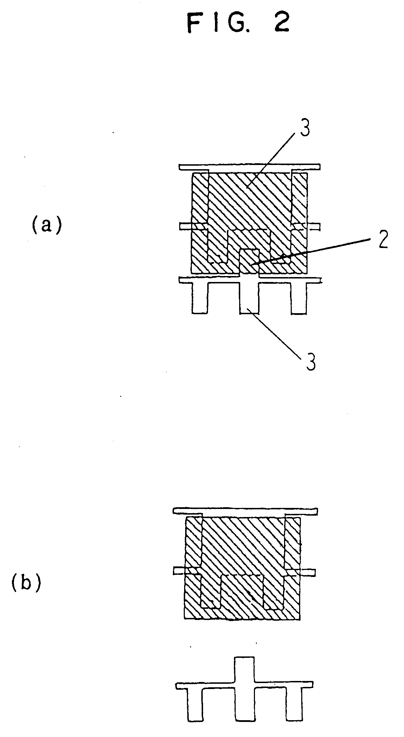

Figure 1 is a plan view of a frame made of copper or 42-alloy for the measurement of the adhesive strength in Examples, wherein numeral 1 (hatched part) denotes a molding portion of a resin composition to be cured. Figure 2(A) is one of the test sample which is cut out from the frame. Figure 2(B) is the test sample after measurement of the adhesive strength. Numeral 2 denotes an area to be peeled off by adding tensile force, and numeral 3 denotes holding parts for tensile test operation.

### DETAILED DESCRIPTION OF THE INVENTION

In the present invention, the epoxy resin of the general formula (1) in which R₁ represents hydrogen or an alkyl group having 1 to 4 carbon atoms is preferable. The epoxy resin of the general formula (1) may be obtained by one of known methods comprising glycidyl etherifying reaction of a phenol. The method is a reaction of a phenol with epihalohydrin in the presence of an alkaline such as sodium hydroxide. Especially, to obtain a highly pured product, the reaction conducted in aprotic solvent is preferable as described in Japanese Patent Kokai 60-31517.

Phenols to be used in the above reaction are represented by the general formula (2): 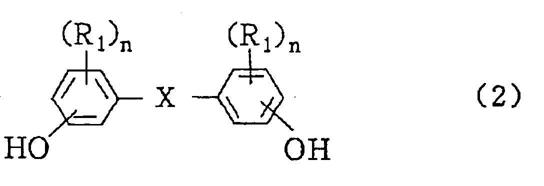
wherein R₁, X and n are the same as those defined for the general formula (1).

Specific examples of the phenols are shown below. 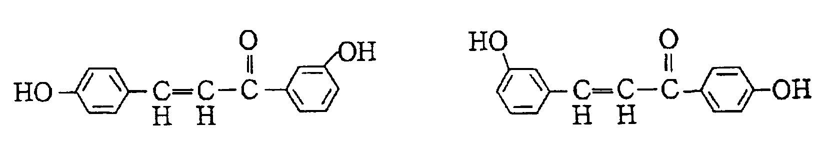 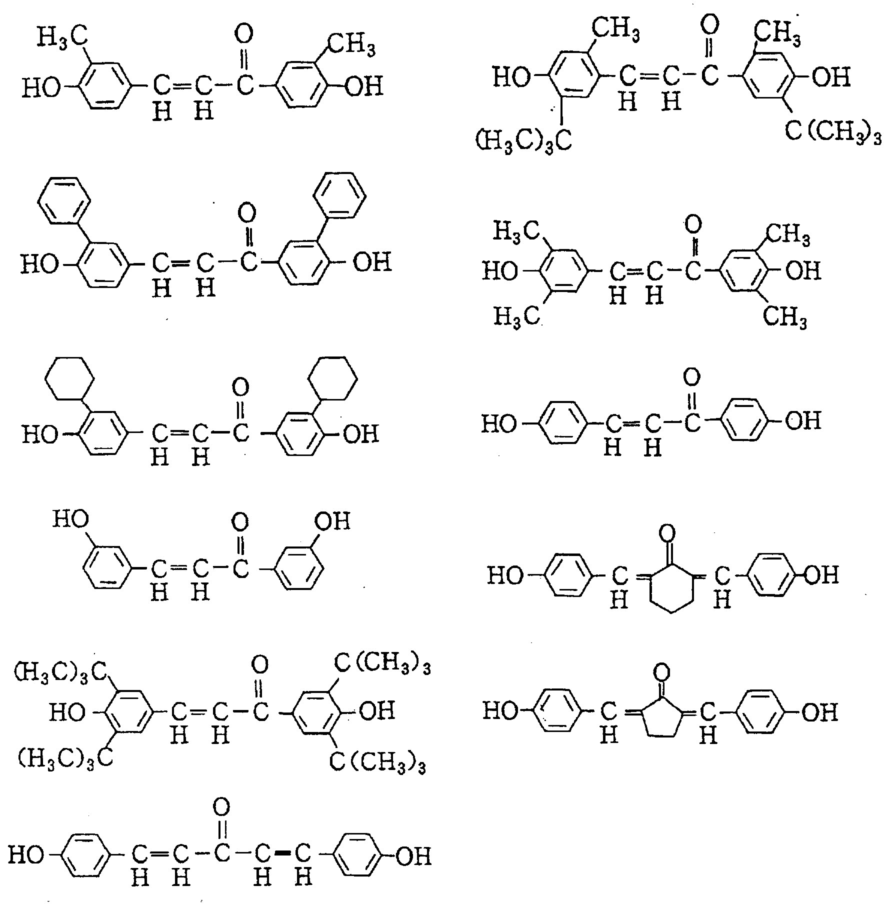
The epoxy resin, the component (A) to be used in the composition according to the present invention may be used as alone as well as in a mixture with any one of known epoxy resins. Exemplary epoxy resins include novolak epoxy resins such as the reaction products of a phenol such as phenol, o-cresol or the like with a formaldehyde; glycidyl ether compounds derived from tri- or higher valent phenols such as phloroglucin, tris-(4-hydroxyphenyl)-methane, 1,1,2,2-tetrakis (4-hydroxyphenyl)-ethane and the like; glycidyl ether compounds derived from divalent phenols such as bisphenol A, bisphenol F, tetramethylbisphenol, hydroquinone, resorcin, 4,4'-thio-di(2,6-dimethylphenol), dihydroxynaphthlene, bis(hydroxyphenyl)dicyclopentane, bis(hydroxyphenyl)mentane and the like , or halogenated bisphenols such as tetrabromobisphenol A, and the like; glycidyl ether compounds of polyhydric phenols produced by condensation of phenols with aromatic carbonyl compounds; amine based epoxy resins derived from p-aminophenol, m-aminophenol, 4-amino-m-cresol, 4,4'-diaminodiphenyl methane, 3,3'-diaminodiphenyl methane, 4,4'-diaminodiphenyl ether, 3,4'-diaminodiphenyl ether, 1,4-bis(4-aminophenoxy)benzene, 1,4-bis(3-aminophenoxy)benzene, 1,3-bis(4-aminophenoxy) benzene, 1,3-bis(3-aminophenoxy)benzene, 2,2-bis(4-aminophenoxyphenyl)propane, p-phenylene diamine, m-phenylene diamine, 2,4-toluene diamine, 2,6-toluene diamine, p-xylylene diamine , m-xylylene diamine, 1,4-cyclohexane-bis(methylamine), 1,3- cyclohexane-bis(methylamine) and the like; glycidyl ester compounds derived from aromatic carboxylic acids such as p-oxybenzoic acid, m-oxybenzoic acid, tetraphthalic acid, isophthalic acid; hydantoic epoxy compounds derived from 5,5-dimethyl hydantoin, and the like; alicyclic epoxy resins of 2,2-bis(3,4-epoxycyclohexyl)propane, 2,2-bis[4-(2,3-epoxypropyl) cyclohexyl]propane, vinylcyclohexene dioxide, 3,4-epoxycyclohexylmethyl-3,4-epoxycyclohexane carboxylate, and the like; N, N-diglycidyl aniline.

The curing agent, the component (B) to be used in the composition according to the present invention may be used any one of known curing agents for epoxy resins. Exemplary curing agents include polyvalent phenols such as phenol novolak, aralkylphenol novolak, and the like; amines such as dicyandiamide, diaminodiphenylmethane, diaminodiphenyl sulfone and the like; acid anhydrides such as pyromerit anhydride, trimerit anhydride, benzophenonetetr acarboxylic acid anhydride and the like. Polyvalent phenols are preferable from a viewpoint of low hygroscopicity.

The phenol curing agents are further exemplified as polycondensation products of one or more phenols and aldehydes or ketones. As phenols, phenol, various alkyl phenols, naphtol and the like may be used. As aldehydes, formaldehyde, acetaldehyde, acrolein, glyoxal, benzaldehyde, naphtaldehyde, hydroxybenzaldehyde and the like may be used; and as ketones, cyclohexanone, acetophenone and the like may be used.

Vinyl polymerizable type polyvalent phenols such as polyvinylphenol, polyisopropenylphenol and the like, and Friedel-Crafts reaction products of phenols may be used. Compounds used for Friedel-Crafts reaction with phenols are diol compounds represented by the formula below; 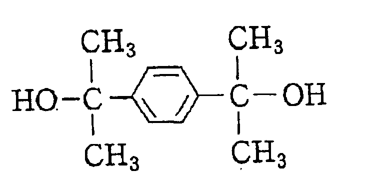
dialkoxy compounds represented by the formula below; 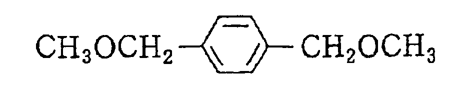
dihalogen compounds represented by the formula below; 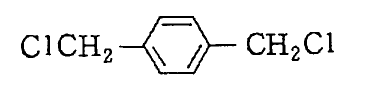
and diolefin compounds such as dicyclopentadiene, diisopropenyl benzene and the like. These curing agents may be used as alone as well as a mixture of at least two of them.

With respect to the proportion of the curing agents to the epoxy resins to be incorporated in the composition of the present invention, the amount of the curing agents to be used is 0.7 to 1.2 equivalents based on the epoxy group. An amount of lower than 0.7 equivalent or over 1.2 equivalents based on the epoxy group result in insufficient curing.

In case the resin composition of the present invention is to be cured, known curing promotors may be employed. Exemplary curing promotors include organic phosphine compounds such as triphenyl phosphin, tri-4-methylphenyl phosphine, tri-4-methoxy phenyl phosphine, tributyl phosphine, trioctyl phosphine, tri-2-cyanoethylphosphine, and the like, and tetraphenylborate salts thereof; tertiary amines such as tributylamine, triethylamine, 1,8-diazabicyclo[5,4,0]undecen-7, triamylamine, and the like; quaternary ammonium salts such as ammonium benzyl trimethylchloride, ammonium benzyl trimethyl hydroxide, triethylammonium tetraphenylborate, and the like; and imidazoles, without being limited thereto. Among them, organic phosphine compounds, 1,8-diazabicyclo[5,4,0]undecen-7, and imidazoles are preferred from the standpoint of resistance to humidity and curability, inter alia, triphenyl phosphine is more preferred.

Furthermore, to the composition of the present invention, there may be added (C) inorganic fillers. The fillers include silica, alumina, titanium white, aluminum hydroxide, talc, clay and glass fibers. Especially, silica and alumina are preferred. These may be used in a mixture of different shapes (sphere or crushed types) and different sizes to increase the filler content. The proportion of the inorganic fillers to be incorporated for use in encapsulating semiconductors is in the range of 25 to 92 % by weight, preferably 70 to 92 % by weight based on the total of the resin composition. A proportion less than 25 % by weight may result in void generation in the molded articles because of insufficient pressure during mold processing, while a proportion higher than 92 % by weight results in problematic processability.

To the composition of the present invention, there may be added mold releasing agents such as naturally occurring waxes, synthetic waxes, higher fatty acids and metal salts thereof, or paraffins; coloring agents such as carbon black; surface treating agents such as silane coupling agents, and the like. In addition, flame retardants such as antimony trioxide, phosphorus compounds, brominated epoxy resins, and the like may be added. In order to achieve the flame retarding effects, the use of brominated epoxy resin is preferred.

In order to reduce stress imposed, various elastomers may be added or pre-reacted. Practically, one may make mention of additive or reactive type elastomers such as polybutadiene, butadiene-acrylonitrile copolymer, silicone rubbers, solicone oils, and the like.

With the resin composition of the present invention, resin-encapsulated semiconductor devices can be made by molding and curing in accordance with any one of known prior forming techniques such as transfer molding, compression molding, injection molding and the like.

### PREFERRED EMBODIMENTS OF THE INVENTION

The present invention will be illustrated with reference to the following Examples, without being limited thereto. In Examples, epoxy equivalent weight is defined as a molecular weight of an epoxy resin per epoxy group.

A hydrolyzable chlorine content of an epoxy resin is determined by reverse titration of isolated chlorine with silver nitride aqueous solution, said isolated cholorine is generated by adding alcoholic solution of potassium hydroxide to dioxane solution of an epoxy resin, and refluxing it for 30 minutes.

Blends and cured shapes were evaluated as follows:
Gel time: Measured by a Gellation Tester at 180°C (Nisshin Kagaku Co., Ltd.).

Barcol hardness: Determination was effected with a hardness tester model 935 under the condition of 175°C /90 seconds according to ASTM D-648.

Glass transition temperature: Determination was effected using a thermomecanical analyzer (SHIMADZU DT-30).

Flexural strength, flexural modulus: Determination was made with an Instron universal tester (SHIMADZU IS-10T) according to JIS K-6911.

Water absorbance: A variation in weight was measured at a temperature of 85°C and a relative humidity of 85 % using a constant temperature humidity incubator (Advantec Toyo, AGX-326).

Spiral flow: Conducted at a temperature of 175 °C and at 70 kg/cm² according to EMMI-1-66.

Adhesive strength: A sample was transfer molded on a copper-frame and 42 alloy-frame, and evaluated the adhesive strength.

Solder cracking property: A simulated IC (QFP package with 52 pins, a package thickness of 2.05 mm) was moistened under the conditions of a temperature of 85°C and a relative humidity of 85 % for 72 hours, and immediately thereafter immersed in a soldering bath at 240 °C for 30 seconds, followed by counting the number of ICs having cracks generated. The number of tested ICs was eight.

### Referential Example 1:

### (Synthesis of a phenol as a raw material)

Into a 3-ℓ reactor equipped with a thermometer, a stirrer and a condenser, 136.2 g (1.0 mol) of p-hydroxyactophenone, 122.1 g (1.0 mol) of p-hydroxybenzaldehyde and 600 g of methanol were charged, and after dissolved, 51.0 g (0.50 mol) of a 97 % sulfuric acid were added, raised the temperature to 60°C , and then the whole was kept at the same temperature for 13 hours as it was. The reaction mixture was poured into water for crystallization. The obtained crystal was filtered and washed 4 times with 1000 g of water, and then dried in vacuo at 80°C for 5 hours. Red colored crystal having a melting point of 164 °C by DSC was obtained (this is referred to as DHCNP hereunder).

### Referential Example 2:

### (Synthesis of a phenol as a raw material)

Into a 3-ℓ reactor, 136.2 g (1.0 mol) of m-hydroxyactophenone, 122.1 g (1.0 mol) of p-hydroxybenzaldehyde and 640 g of methanol were charged, and after dissolved, 51.0 g (0.50 mol) of a 97 % sulfuric acid were added, raised the temperature to 60 °C , and then the whole was kept at the same temperature for 10 hours as it was. The reaction mixture was poured into water for crystallization. The obtained crystal was filtered and washed 4 times with 1000 g of water, and then dried in vacuo at 80°C for 5 hours. Red-brown colored crystal having a melting point of 181 °C was obtained (this is referred to as DHCNM hereunder).

### Referential Example 3:

### (Synthesis of a phenol as a raw material)

Into a 3-ℓ reactor, 49.1 g (0.5 mol) of cyclohexanone, 122.1 g (1.0 mol) of p-hydroxybenzaldehyde and 400 g of ethanol were charged, and after dissolved, 50.8 g (0.50 mol) of a 36 % hydrochloric acid were added, raised the temperature to 80°C , and then the whole was kept at the same temperature for 6 hours as it was. The obtained crystal was filtered and washed 4 times with 1000 g of water, and then dried in vacuo at 80 °C for 5 hours. Brown colored crystal having a melting point of 284 °C was obtained (this is referred to as DHCH hereunder).

### Referential Example 4:

### (Synthesis of an epoxy resin)

Into a reactor equipped with a thermometer, a stirrer, a funnel and a condenser having a separating tube, 120.0 g of phenol DHCNP obtained in the referetial example 1, 647.5 g of epichlorohydrin and 323.8 g of dimethylsulfoxide were charged, and after dissolved, 82.82 g of a 48.3 % sodium hydroxide were added droppwisely for 5 hours, under the reaction condition of at 43 torr and 48°C . Meanwhile, keeping the reaction temperature at 48 °C , azeotropically vaporized epichlorohydrin and water were liquified by cooling, and the organic layer was supplied back into the reaction phase to continue the reaction. Unreacted epichlorohydrin was removed by evaporation, and glycidyl ether product was dissolved in 413 g of methylisobutylketone and washed with water to remove a by-product-salt and dimethylsulfoxide contained in it. Methylisobutylketone was distilled off at 170°C / 10 torr. and the glycidyl ether product having a melting point of 106 °C , melt viscosity of 0.22 poise /150 °C and epoxy equivalent value of 190 g/ eq. was obtained (this is referred to as DHCAP-E hereunder).

### Referential Example 5:

### (Synthesis of an epoxy resin)

Into a reactor equipped with a thermometer, a stirrer, a funnel and a condenser having a separating tube, 120.0 g of phenol DHCNM obtained in the referetial example 2, 647.5 g of epichlorohydrin and 323.8 g of dimethylsulfoxide were charged, and after dissolved, 82.82 g of a 48.3 % sodium hydroxide were added droppwisely for 5 hours, under the reaction condition of at 43 torr and 48°C . Meanwhile, keeping the reaction temperature at 48 °C , azeotropically vaporized epichlorohydrin and water were liquified by cooling, and the organic layer was supplied back into the reaction phase to continue the reaction. Unreacted epichlorohydrin was removed by evaporation, and glycidyl ether product was dissolved in 413 g of methylisobutylketone and washed with water to remove a by-product-salt and dimethylsulfoxide contained in it. Methylisobutylketone was distilled off at 170°C / 10 torr. and the glycidyl ether liquid product having a melt viscosity of 0.42 poise /150 °C and epoxy equivalent value of 186 g/ eq. was obtained (this is referred to as DHCAM-E hereunder).

### Referential Example 6:

### (Synthesis of an epoxy resin)

Into a reactor equipped with a thermometer, a stirrer, a funnel and a condenser having a separating tube, 120.0 g of DHCH obtained in the referetial example 3, 507.3 g of epichlorohydrin and 253.7 g of dimethylsulfoxide were charged, and after dissolved, 64.88 g of a 48.3 % sodium hydroxide were added droppwisely for 5 hours, under the reaction condition of at 43 torr and 48°C . Meanwhile, keeping the reaction temperature at 48 °C , azeotropically vaporized epichlorohydrin and water were liquified by cooling, and the organic layer was supplied back into the reaction phase to continue the reaction. After the reaction, unreacted epichlorohydrin was removed by evaporation, and glycidyl ether product was dissolved in 950.0 g of methylisobutylketone and washed with water to remove a by-product-salt and dimethylsulfoxide contained in it. Methylisobutylketone was distilled off at 170°C / 10 torr. and the glycidyl ether product having a melting point of 125 °C , melt viscosity of 0.33 poise /150 °C and epoxy equivalent value of 224.6 g/ eq. was obtained (this is referred to as DHCH-E hereunder).

### Referential Example 1-5, Comparative Example 1-2

Using the glycidyl ethers obtained in the Referential Examples 4-5 as described above (DHCAP-E, DHCAM-E and DHCH-E), and a glycidyl ether of o-cresol novolak (available from Sumitomo Chemical Co., Ltd. under the trade name of Sumi-Epoxy ESCN-195, an epoxy equivalent of 195 g/eq., softening point of 65.6 °C , melt viscosity of 2.6 poise (150°C ) and a phenol novolak (available from Gunei Kagaku Kogyo Co., Ltd. under the trade name of PSM-4261, softening point of 81°C ) as a curing agent, triphenyl phosphine as curing accelerator, fused silica shown below as a filler, carnauba wax as a mold releasing agent, and a coupling agent (available from Toray Dow Corning Silicone, under the trade name of SH-6040) were incorporated in amounts (g) as indicated in Table 1, heat-kneaded with a roll, and transfer molded.

Moreover, the moldings were post-cured for 5 hours in an oven at a temperature of 180°C ) to produce cured shapes. The results are set forth in Table 2. The fused silica used in the example were as follows;
FS-891: Crashed silica (available from Denki Kagaku Kogyo Co.,Ltd., mean diameter of 13µm).
FS-20: Crashed silica (available from Denki Kagaku Kogyo Co.,Ltd., mean diameter of 5.6µm).
FS-891: Spherical silica (available from Denki Kagaku Kogyo Co.,Ltd., mean diameter of 30µm).
Adomafine SOC-2: Spherical silica (available from Adomatec Co., Ltd., mean diameter of 0.4 µm).
Silstar MK-06: Spherical silica (available from Nippon Kagaku Kogyo Co., Ltd., mean diameter of 4.9µm).
Excelica SE-40: Spherical silica (available from Tokuyama Soda Co., Ltd., mean diameter of 40.4µm).

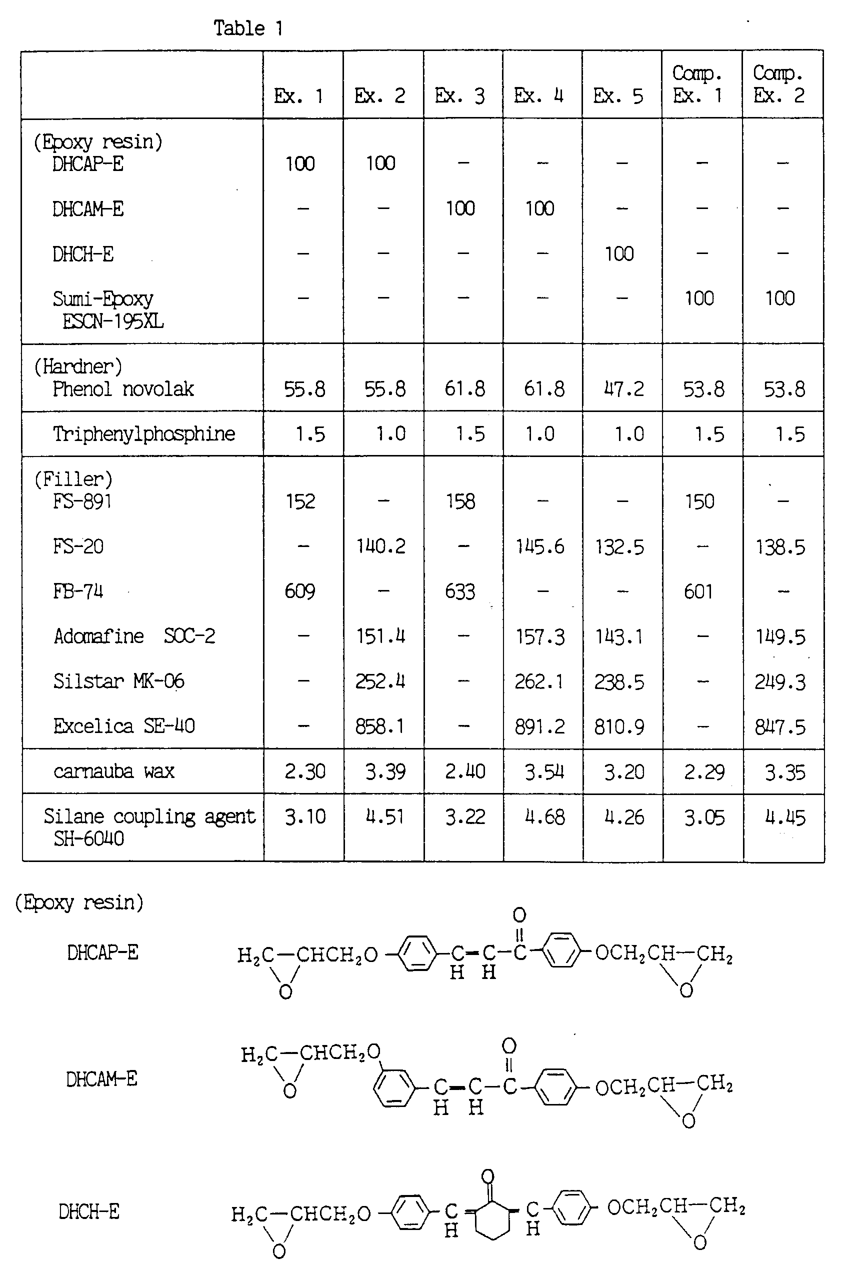

**Table 2**

| | Ex. 1 | Ex. 2 | Ex. 3 | Ex. 4 | Ex. 5 | Comp. Ex. 1 | Comp. Ex. 2 |
|---|---|---|---|---|---|---|---|
| Gel time (Sec) | 23 | 31 | 24 | 30 | 29 | 33 | 25 |
| Spiral flow (inch) | 24.0 | 26 | 29.5 | 30.2 | 23.0 | 20.0 | 3 |
| Barcol hardness | 74 | 80 | 77 | 81 | 78 | 80 | ¹⁾Not measured |
| Glass transiton temp | 176 | 165 | 156 | 160 | 162 | 153 | |
| Flexural strength at 20 °C (kg/mm²) | 15.3 | 16.3 | 17.0 | 16.5 | 17.5 | 12.4 | |
| Flexural modulus at 20 °C (kg/mm²) | 1810 | 2470 | 1910 | 2500 | 2700 | 2620 | |
| Flexural strength at 120°C (kg/mm²) | 1.72 | 2.62 | 1.14 | 2.21 | 2.96 | 1.51 | |
| Flexural modulus at 120°C (kg/mm²) | 153 | 320 | 111 | 280 | 292 | 190 | |
| Adhesive Strength to Copper frame (kg/mm²) | 0.088 | 0.085 | 0.089 | 0.090 | 0.085 | 0.033 | |
| Adhesive Strength to 42 frame (kg/mm²) | 0.073 | 0.070 | 0.080 | 0.082 | 0.081 | 0.028 | |
| % water absorbance 72hr | 0.278 | 0.165 | 0.221 | 0.124 | 0.130 | 0.245 | |
| Soder cracking property | 2 | 0 | 1 | 0 | 0 | 8 | |

| | | | | | | | |
|---|---|---|---|---|---|---|---|
| 1) Preparation of a molded test sample was impossible by bad flowability. | | | | | | | |

The epoxy resin composition of the present invention has low viscosity and cured products thereof have low hygroscopic property and high adhesiveness. The resin-encapsulated semiconductor devices produced with this composition are excellent in resistance to solder-cracking.

As the epoxy resin composition has low viscosity compared with a glycidyl ether of o-cresol novolak and can contain large amount of fillers, so the low hygroscopic property of the composition is improved and the reliability of the product thereof is enhaunced.

## Claims

1. An epoxy resin composition comprising
(A) an epoxy resin represented by the general formula (1) 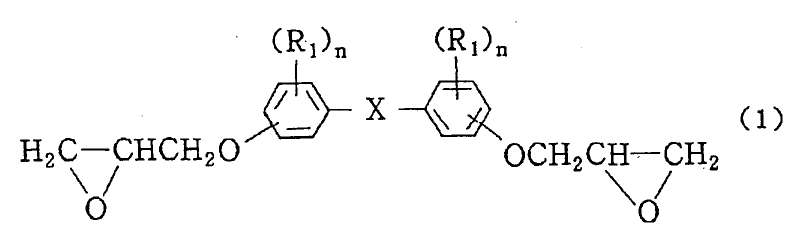 wherein R₁ represents hydrogen, an alkyl group having 1 to 6 carbon atoms, substituted- or nonsubstituted-phenyl groups or halogen, and X represents 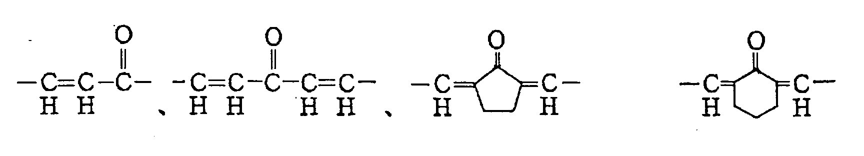 and n represents an integer of 0 to 4, and
(B) a curing agent.

2. An epoxy resin composition according to claim 1, wherein the curing agent (B) is a polyvalent phenol.

3. An epoxy resin composition according to claim 1 or 2, which further comprises (C) an inorganic filler.

4. An epoxy resin composition according to claim 1, wherein the epoxy resin represented by the general formula (1) in which R₁ is hydrogen or an alkyl group having 1 to 4 carbon atoms.

5. An epoxy resin composition according to claim 1 or 2, wherein the curing agent (B) is phenol novolak or aralkyl phenol novolak.

6. An epoxy resin composition according to claim 3, wherein the inorganic filler (C) is silica or alumina.

7. A resin-encapsulated semiconductor device obtained by encapsulating semiconductor device with the epoxy resin composition according any one of claims 1 to 3.
